# EUROPÄISCHE PATENTSCHRIFT

(11) **EP 0 933 823 B1**
(45) Veröffentlichungstag und Bekanntmachung des Hinweises auf die Patenterteilung: **29.08.2018**
(21) Anmeldenummer: 99100385.6
(22) Anmeldetag: 18.01.1999
(51) Int. Cl.: H01L 33/48, H01L 33/50

(54) **Flächenleuchte mit ausdehnungskompensiertem optoelektronischem Halbleiter-Bauelement**
Surface lighting unit with expansion compensated optoelectronic semiconductor device
Unité d'éclairage de surface avec un dispositif semiconducteur optoélectronique compensé pour la dilatation

(30) Priorität: 30.01.1998 DE 19803936
(43) Veröffentlichungstag der Anmeldung: 04.08.1999
(60) Teilanmeldung: 10177644.1
(73) Patentinhaber: OSRAM GmbH, 80807 München (DE); OSRAM Opto Semiconductors GmbH, 93055 Regensburg (DE)
(72) Erfinder: Waitl, Günter, 93049 Regensburg (DE); Langer, Alfred, 86438 Kissing (DE); Weitzel, Reinhard Dr., 82216 Maisach (DE)
(74) Vertreter: Epping - Hermann - Fischer

(56) Entgegenhaltungen:
- EP-A- 0 568 830
- EP-A- 0 658 933
- DE-C1- 19 508 222
- JP-A- H 087 614
- US-A- 5 264 393
- US-A- 5 298 768
- US-A- 5 528 474
- US-A- 5 660 461

## Beschreibung

Die Erfindung betrifft eine Flächenleuchte mit ausdehnungskompensierten optoelektronischen Halbleiter-Bauelementen gemäß dem Oberbegriff des Anspruchs 1. Es handelt sich bei den Halbleiter-Bauelementen um UV-emittierende Leuchtdioden und optional mit Lumineszenzkonversion in weißes Licht. Deren Einsatzgebiet ist hauptsächlich die Allgemeinbeleuchtung. Aber auch reine UV-Anwendungen ohne Lumineszenzkonversion sind möglich. Als Halbleiter wird meist ein Nitrid des Galliums und/oder Indiums und/oder Aluminiums verwendet.

Ein optoelektronisches Halbleiter-Bauelement wie beispielsweise eine Leuchtdiode ist in seiner Anwendungsmöglichkeit eingeschränkt, ohne dass dieser Mangel von der Fachwelt bisher so empfunden wird. Scheinbar ist Kunststoff ideal als Gehäusewerkstoff geeignet, da er leicht verarbeitet werden kann. Weitverbreitet ist die Gießharztechnologie mit Epoxid. Die scheinbar ideale Eignung des Kunststoffs als Gehäusewerkstoff verdeckte bisher den Mangel einer fehlenden Abstimmung seines Ausdehnungsverhaltens bei Temperaturwechselbelastung. Durch die derzeit übliche Verwendung eines Kunststoffgehäuses ist die Arbeitstemperatur auf den Bereich von -55°C bis +110° C eingeschränkt. Außerdem scheiterte ein Einsatz bei sehr kurzen Wellenlängen (im UV-Bereich) bisher an der starken Degradation des Gehäuses.

Für die Erzeugung weißen Lichts für Zwecke der Allgemeinbeleuchtung kommen neuerdings weißes Licht emittierende Leuchtdioden in Frage. Sie basieren auf der Erzeugung des weißen Lichts mittels einer blau oder auch UV-emittierenden Leuchtdiode. Übliche Konzepte zur Realisierung basieren auf radialen Bauformen, die für die Durchsteckmontage (beispielsweise sog. LUCOLED-Design) geeignet sind, oder SMT-geeigneten Bauformen, dem sog. Topled-Design für die Oberflächenmontage (SMT-LED). Genaueres hierzu findet sich beispielsweise in dem Artikel "White-light diodes are set to tumble in price" von Philip Hill, OLE Oktober 1997, S. 17 bis 20. Beim LUCOLED-Konzept wird beispielsweise von einem blauen Emitter auf Basis GaN mittels Luminiszenzkonversion weißes Licht erzeugt.

In dem Artikel "High Power UV InGaNI AlGaN Double Heterostructure LEDs" von Mukai, Morita und Nakamura (Proceedings of the Second International Conference On Nitride Semiconductors, S. 516, 1997, in Tokushima Japan)), ist der Aufbau einer UV-emittierenden Leuchtdiode mit einer Emissionswellenlänge von etwa 370 nm beschrieben. Die Leuchtdiode weist einen Chip auf, der auf einem Leiterrahmen montiert ist und in einem Kunststoffgehäuse eingegossen wird.

In dem Artikel "Reliability Behavior of GaN-based Light Emitting Diodes" von D. Steigerwald (Proceedings of the Second International Conference On Nitride Semiconductors, S. 514 bis 515, 1997, in Tokushima Japan)), werden Leuchtdioden verschiedener Farbe untersucht. Es wurde festgestellt, daß die Degradation der Leuchtdiode mit kürzerer Emissionswellenlänge bis herab zu 470 nm stark zunimmt. Entscheidenden Anteil an der Degradation haben die Faktoren Betriebsstrom und Umgebungstemperatur sowie das Gehäuse aus Kunststoff. Zur Untersuchung wurde das Epoxidharz-Gehäuse vorübergehend entfernt.

Insgesamt erscheint daher der Betrieb einer UV-emittierenden Leuchtdiode bisher wenig erfolgversprechend, da die UV-Strahlung das Gehäuse schädigt. Bei Verwendung eines blau emittierenden Leuchtdiode als Lichtquelle ist jedoch andererseits die Lichtausbeute und Effizienz relativ niedrig (ca. 5 lm/W).

Frühere optoelektronische Halbleiter-Bauelemente hatten als Gehäuse ein Metall-Glas-System, wobei in einer Metallkappe eine Glaslinse eingepasst wurde (siehe PCT-A PCT/DE96/01728). Damit konnte zwar höheren Anforderungen an die optischen Eigenschaften entsprochen werden, aber die Herstellkosten für die Bodenplatte und die Linsenkappe sind unverhältnismäßig hoch, die Fertigung ist sehr aufwendig und die hohen Toleranzen in Fertigung und Justierung erlauben nur bedingt den Einsatz dieser Technologie. Die optische Perfektion des Systems ist daher für viele Applikationen nicht ausreichend.

Die Druckschrift JP H08-007614 A betrifft eine Flächenlichtquelle mit einer blau emittierenden LED, die in einen Kunststofflichtleiter einstrahlt.

Aus der Druckschrift US 5 528 474 A ist ein Fahrzeugleuchte mit einem Array von LEDs in einem Gehäuse bekannt.

Es ist Aufgabe der vorliegenden Erfindung, eine Flächenleuchte bereitzustellen, die sich für einen erweiterten Einsatzbereich hinsichtlich Temperatur und Umgebungsfeuchtigkeit eignet und die in einem Wellenlängenbereich von etwa 300 nm bis 1600 nm arbeiten kann.

Diese Aufgabe wird durch die kennzeichnenden Merkmale des Anspruchs 1 gelöst.

Im einzelnen handelt es sich bei der vorliegende Erfindung um eine Flächenleuchte mit optoelektronischen Halbleiter-Bauelementen, bei denen ein strahlungsemittierender Halbleiterkörper auf einem elektrisch leitenden Leiterrahmen befestigt ist und von einem gasdichten Gehäuse umgeben ist. Alle eingesetzten Gehäusematerialien und der Leiterrahmen weisen im Temperaturbereich, der in Herstellung und Anwendung auftritt, aneinander angepasste thermische Ausdehnungskoeffizienten auf.

Vorteilhaft hat das Gehäuse einen Grundkörper mit einer Ausnehmung, wobei der Grundkörper an dem Leiterrahmen gasdicht befestigt ist. Der Halbleiter-Chip ist in der Ausnehmung auf dem Leiterrahmen befestigt Die Ausnehmung ist evtl. mit einer separaten Abdeckung gasdicht verschlossen oder befindet sich im Grundkörper.

Der Grundkörper und optional die Abdeckung ist aus Glas oder Quarzglas oder Keramik oder Glaskeramik gefertigt. Die einzelnen Materialien sind im Temperaturbereich von -60 °C bis 150 °C optimal aufeinander abgestimmt. Damit lässt sich die Junctiontemperatur T_{J} von derzeit 100 °C auf 130 °C und mehr erhöhen. Dadurch sind LEDs im Außenbereich bis zu einer Umgebungstemperatur von etwa 100 °C einsetzbar, so dass sie sich für Automobilanwendungen oder Outdoor-Informationssysteme eignen.

Die erfindungsgemäße Flächenleuchte besitzt den Vorteil, dass konventionelle Methoden der Befestigung unter Hochtemperaturbedingungen für den Halbleiterchip auf dem Leiterrahmen angewendet werden können. Bei den derzeit verwendeten Kunststoffgehäusen ist dies aufgrund der Temperaturempfindlichkeit von Kunststoff nicht möglich. Statt dessen werden hier Leitkleber, die beispielsweise Ag enthalten, verwendet.

Ein weiterer Vorteil der erfindungsgemäßen Flächenleuchte besteht darin, dass eine höhere Stabilität erzielt wird, weil Grenzschichteffekte zwischen Halbleiterchip und Kunststoffumhüllung ausgeschlossen sind. Weder im Langzeitbetrieb noch beim Löten tritt Delamination auf, so daß die Lichtauskopplung stabilisiert ist.

Ein besonderer Vorteil der vorliegenden Erfindung besteht insbesondere darin, daß damit erstmals grundsätzlich die Möglichkeit geboten wird, eine UV-emittierende Leuchtdiode bereitzustellen, die eine hohe Lichtausbeute und Effizienz besitzt und die sich preisgünstig herstellen läßt. Dies liegt nicht nur an der grundsätzlichen fertigungsfreundlichen Konzeption, sondern auch daran, daß unter den jetzt zum Einsatz kommenden Materialien sich auch solche mit hoher Transparenz im UV und Beständigkeit gegen UV-Strahlung befinden, beispielsweise Quarzglas. Für Kunststoffe ist diese Anforderung praktisch nicht zu erfüllen.

Des weiteren tritt keine mechanische Zug- und Druckbeanspruchung des Halbleiterchips auf. Folglich gibt es keine streßinjizierte Degradation.

Die heute bei Kunststoff auftretende Vergilbung durch Temperatur und UV-Einwirkung, die eine Verringerung der Lichtleistung im sichtbaren Spektrum zur Folge hat, tritt bei der erfindungsgemäßen Flächenleuchte nicht auf.

Der Leiterrahmen besteht aus an sich bekanntem KupferManteldraht oder einem Material mit ähnlichem Ausdehnungsverhalten, also Ni-Fe-Legierungen. Unter KupferManteldraht wird ein Draht verstanden, dessen Seele aus einer Ni-Fe-Legierung und dessen Mantel aus Kupfer besteht.

Meist ist das Gehäuse mehrteilig aus Einzelteilen zusammengesetzt, wobei die Einzelteile gasdicht miteinander verbunden sind, insbesondere durch direkte Verschmelzung oder durch Klebemittel. Dabei eignen sich besonders org. oder anorg. Kleber, beispielsweise Wasserglas.

Die Abdeckung auf dem Rahmenteil sitzt beispielsweise großflächig über der Oberfläche des Rahmens einschließlich der Ausnehmung oder ist nur im Bereich der Ausnehmung positioniert.

Vorteilhaft wird als Material für das Gehäuse niedrigschmelzendes Glas verwendet, vorteilhaft Weichglas, insbesondere Bleiglas oder Alkaliglas. Es ist typisch ab 400 °C verarbeitbar. Der thermische Ausdehnungskoeffizient liegt etwa bei 8 bis 11 x 10⁻⁶/K.

Die Differenz zwischen den thermischen Ausdehnungskoeffizienten einzelner Teile des Gehäuses sollte nicht größer als ± 15 % sein. In diesem Sinne sind obige Komponenten gut aufeinander abgestimmt, wenn beispielsweise als Leiterrahmen bzw. Metalldurchführung eine Einschmelzlegierung des Typs VACOVIT oder VACON oder VACODIL verwendet wird. Diese enthalten Ni, Fe als Hauptbestandteile der Legierung, denen Cr oder Co zugesetzt sein kann (auch für Keramik geeignet).

Die Herstellung der erfindungsgemäßen optoelektronischen Halbleiter-Bauelemente der Flächenleuchte kann auf verschiedene Weise erfolgen. Ein vorgestanztes Leiterband kann mit Preßglas teilen oder Sinterglasteilen beaufschlagt werden, die dann miteinander verklebt werden. Oder es werden von einem Glasrohling (Stab) Einzelstücke abgeschnitten, mit dem Leiterrahmen in Kontakt gebracht, erhitzt und formgepreßt. Auf diese Weise wird der Leiterrahmen direkt in das Gehäuse eingebettet und die Einzelteile des Gehäuses werden miteinander verschmolzen.

Ein Sockel/Kappen-Aufbau kann einstückig realisiert werden. Oft ist es aber fertigungsfreundlicher, diesen Aufbau zweistückig zu realisieren., wobei auch hier ein Verschmelzen in Frage kommt.

Die Flächenleuchte ist aus mehreren LEDs als Einzelpixel eines Arrays aus mehreren Reihen und Spalten zusammengesetzt. Vorteilhaft werden die Einzelpixel gesondert elektronisch angesteuert.

Dabei kann die Flächenleuchte nicht nur als Lichtquelle, sondern auch teilweise (beispielsweise eine Reihe des Arrays) oder ganz als Informationsmedium eingesetzt werden, indem LEDs ein Piktogramm o.ä. formieren. Eine andere Realisierung ist eine kugelförmige Lampe, die innen einen Zuleitungsstab besitzt, wobei mehrere Einzelpixel um den Stab herum gruppiert sind.

Für den Einsatz für Allgemeinbeleuchtungszwecke kann eine Flächenlampe so hergestellt werden, daß eine Anzahl Grundelemente (Einzelpixel), die zu einer Lampe zusammengefaßt werden, vollkonfektioniert oder teilkonfektioniert ohne Abdeckung bzw. ohne Linse auf ein ebenes Substrat (Träger) aufgebracht und verschaltet werden. Sie werden von einem gemeinsamen äußeren Gehäuse umgeben. Eine etwaige Lumineszenzkonversion kann hier durch eine gemeinsame Abdeckung realisiert werden. Hierdurch kann eine extrem flache Bauweise erzielt werden. Die Fläche des Trägers kann auch beliebig geformt sein, beispielsweise als Kugel oder Rundstab. Da das Basiselement ein Halbleiter-Bauteil ist, kann die benötigte Ansteuerelektronik auf dem gleichen Substrat integriert werden, beispielsweise mittels Siebdruck oder SMT. Auch Dimmung ist über einen weiten Bereich möglich. Flächenhafte Lampen können durch direkte Chipmontage in erfindungsgemäß hergestellten Multichip-Gehäusen hergestellt werden. Dabei sind auch Module möglich, die weißes Licht durch drei Einzelkomponenten (Rot, Grün, Blau) erzeugen. Schließlich ist hiermit auch eine gezielte stufenlos regelbare Einstellung der Farbtemperatur möglich. Als Beispiel wird auf eine Grundbaueinheit mit weißem Licht verwiesen, der weitere einzelne Komponenten, die rote oder blaue Anteile zur Senkung oder Erhöhung der Farbtemperatur beitragen, zugemischt werden.

Im folgenden soll die Erfindung anhand mehrerer Zeichnungen näher erläutert werden. Es zeigen:
- Figur 1: ein Halbleiter-Bauelement, im Schnitt
- Figur 2: ein Halbleiter-Bauelement, in perspektivischer Explosionsdarstellung
- Figur 3: ein Ausführungsbeispiel einer Flächenleuchte
- Figur 4: eine nicht erfindungsgemäße Lampe

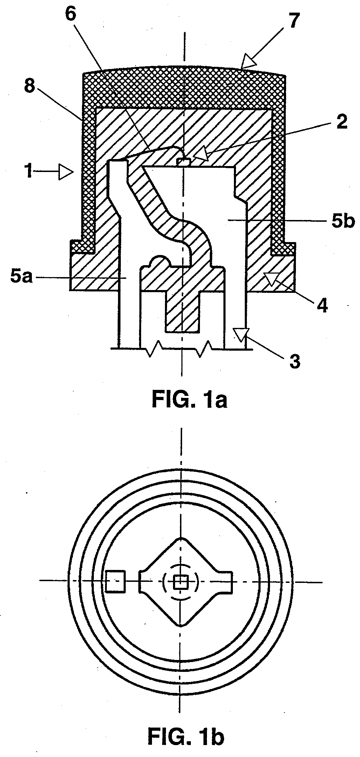

In Figur 1 ist eine Leuchtdiode 1 gezeigt in Schnitt (Figur 1a) und Draufsicht (Figur 1b). Die Leuchtdiode 1 weist einen Halbleiterchip 2 auf, der auf einem Leiterrahmen 3 befestigt ist. Der Chip 2 ist elektrisch leitend mit zwei durch ein Bodenteil 4 hindurchgeführten Elektrodenanschlüssen 5, die Bestandteile des Leiterrahmens sind, verbunden. Ein Kontaktdraht 6 bewirkt die Verbindung des Chips 2 mit dem einen Elektrodenanschluß 5a, während die elektrische Verbindung mit dem anderen Elektrodenanschluß 5b durch Bondverbindung der elektrisch leitenden Unterseite des Chips mit der Trägerfläche, die einstückig mit dem Elektrodenanschluß 5b ausgebildet ist, bewerkstelligt wird. Die zur optischen Abbildung des Chips vorgesehene Linse 7 ist als oberes Abschlußteil einer hohlzylindrischen Kappe 8 ausgebildet. Die Kappe 8 umgibt einen wesentlichen Teil des Bodenteils 4.

Das Bodenteil wie auch die Kappe sind beispielsweise aus Bleiglas der folgenden Zusammensetzung hergestellt: SiO₂ 60-65 Gew.-%; PbO 20-22 Gew.-%; K₂O 4-10 Gew.-%; Na₂O 4-7 Gew.-%. Ein anderes Bleiglas hat die Zusammensetzung SiO₂ 46-50 Gew.-%; PbO 37-42 Gew.-%; K₂O 0.5-5 Gew.-%; Na₂O 7-13 Gew.-%; Al₂O₃ 0-2 Gew.-%.

Es eignen sich auch bleifreie Gläser als Ersatz für Bleiglas, wie sie beispielsweise in US 5 391 523, EP-A 734 051, EP-A 603 933 und DE-A 195 47567 beschrieben sind. Dort sind auch weitere geeignete Durchführungen beschrieben.

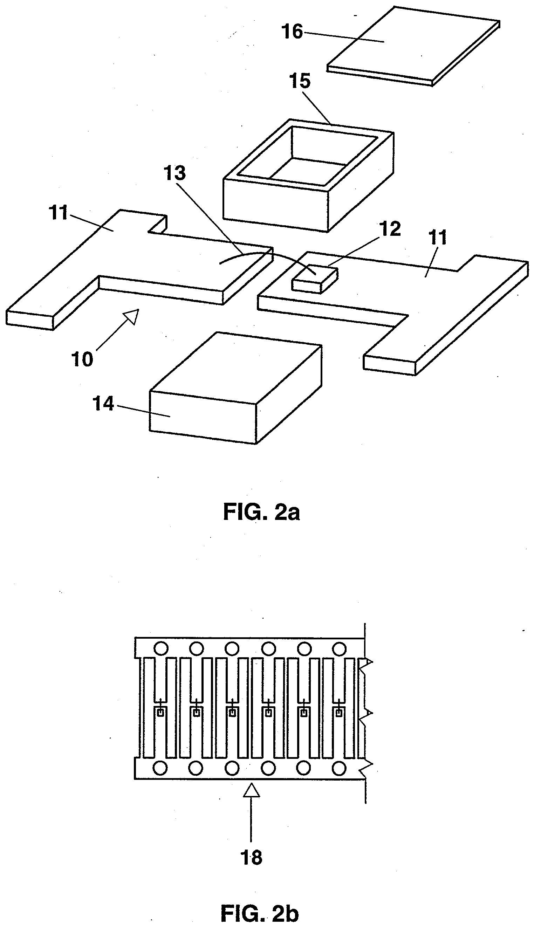

Figur 2a zeigt eine weitere Leuchtdiode in Topled-Ausführung. Der Leiterrahmen 10 besteht aus zwei metallischen Bändern 11, von denen eines in an sich bekannter Weise mit dem Chip 12 bestückt ist. Ein Kontaktdraht 13 verbindet den Chip 12 mit dem zweiten Band. Das Gehäuse besteht hier aus einem quaderförmigen Bodenteil 14, das von unten an den Leiterrahmen 10 geklebt wird. Ein rechteckiges Rahmenteil 15 wird von oben auf den Leiterrahmen 10 befestigt. Zusätzlich wird eine Abdeckung 16 benötigt, die das Rahmenteil nach oben abschließt und vorteilhaft optische Eigenschaften besitzt. Die Abdeckung wird dann nicht unbedingt benötigt, wenn die Leuchtdiode als Einzelelement (Pixel) einer Flächenleuchte eingesetzt wird. In Figur 2b ist ein Chipträgerband 18, bestehend aus einer Vielzahl von miteinander verbundenen Leiterrahmen zur Herstellung eines optoelektronisches Halbleiter-Bauelements gezeigt.

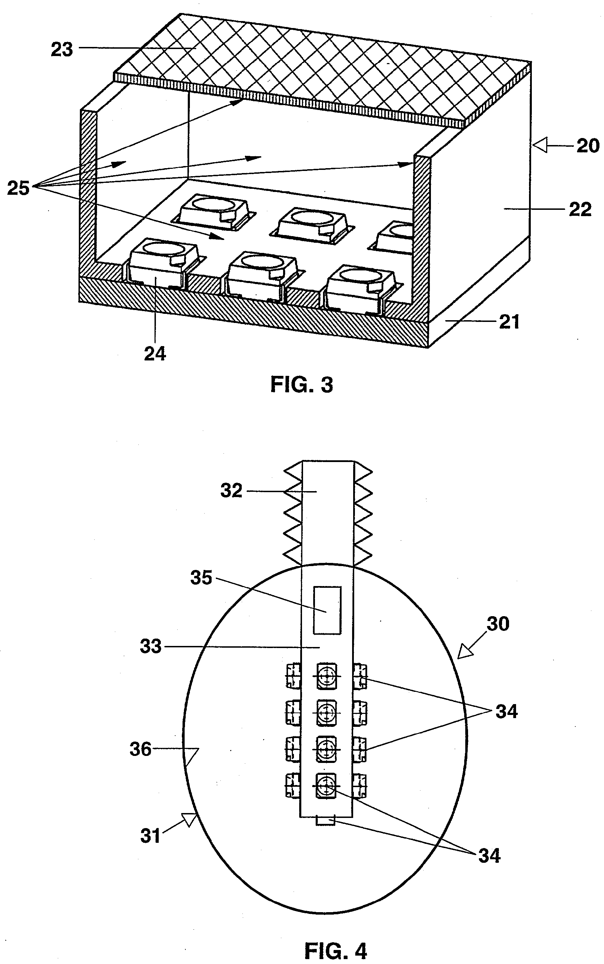

In Figur 3 ist ein Ausschnitt aus einer Flächenleuchte 20 gezeigt. Sie besteht aus einem gemeinsamen Träger 21, auf den ein quaderförmiges äußeres Gehäuse 22 aufgeklebt ist. Seine Oberseite ist mit einer gemeinsamen Abdeckung 23 versehen. Das quaderförmige Gehäuse besitzt Aussparungen, in denen einzelne Halbleiter-Bauelemente 24 untergebracht sind. Die Halbleiter-Bauelemente 24 sind UV-emittierende Leuchtdioden. Die Umwandlung in weißes Licht erfolgt mittels Konversionsschichten 25, die auf allen der UV-Strahlung zugänglichen Flächen angebracht ist. Dazu zählen die innen liegenden Oberflächen der Seitenwände des Gehäuses, der Abdeckung und des Bodenteils. Die einzelnen Pixel sind ähnlich wie in Figur 2 dargestellt aufgebaut.

Ein nicht erfindungsgemäßes Beispiel einer Kompaktlampe 30 auf der Basis von Leuchtdioden ist in Figur 4 dargestellt. Die Kompaktlampe ähnelt äußerlich bekannten Lampen, indem als äußeres Gehäuse ein kugeliger Außenkolben 31 auf einem Schraubsockel 32 sitzt. Der Sockel 32 trägt einen Rundstab 33, der sich weit in den Außenkolben 31 hinein erstreckt. Der Rundstab 33 bildet einen Träger, der auf seiner Oberfläche mit Leuchtdioden 34 bestückt ist. Im Inneren des Rundstabs 33 ist die Elektronik 35 verborgen. Der Außenkolben 31 ist innen mit einer Konversionsschicht 36 bedeckt. Die Leuchtdioden emittieren beispielsweise UV oder blaues Licht.

## Patentansprüche

1. Flächenleuchte (20) mit einer Mehrzahl von LEDs (1, 24) als Einzelpixel eines Arrays aus mehreren Reihen und Spalten, die auf einem Träger (21) aufgebracht und verschaltet sind und von einem gemeinsamen äußeren Gehäuse (22) umgeben sind, **dadurch gekennzeichnet, dass**
- die LEDs (1, 24) jeweils einen strahlungsemittierenden Halbleiterkörper (2, 12) auf einem elektrisch leitenden Leiterrahmen (3, 10) und ein Gehäuse (8, 15), welches den Halbleiterkörper (2, 12) umgibt, umfassen,
- die Materialien des Gehäuses (8, 15) der LEDs (1, 24) und des Leiterrahmens (3, 10) im Temperaturbereich, der in Herstellung und Anwendung auftritt, aneinander angepasste thermische Ausdehnungskoeffizienten aufweisen, indem
- das Gehäuse (8, 15) der LEDs (1, 24) einen Grundkörper aufweist, der aus Glas oder Quarzglas oder Keramik oder Glaskeramik gefertigt ist,
- der Leiterrahmen (3, 10) aus einer Ni-Fe-Legierung oder aus einem Kupfermanteldraht mit einer Seele aus einer Ni-Fe-Legierung und einem Mantel aus Kupfer besteht, und
- die LEDs (1, 24) im UV Bereich emittieren.

2. Flächenleuchte nach Anspruch 1, bei der die LEDs (1, 24) ein Piktogramm formieren.

## Claims

1. A surface light source (20) comprising a plurality of LEDs (1, 24) as individual pixels of an array of a plurality of rows and columns which are arranged on a carrier (21) and which are surrounded by a common outer housing (22), **characterized in that**
- the LEDs (1, 24) each have a radiation-emitting semiconductor body (2, 12) on an electrically conductive lead frame (3, 10) and have a housing (8, 15) which surrounds the semiconductor body (2, 12),
- the materials of the housing (8, 15) of the LEDs (1, 24) and of the lead frame (3, 10) have thermal expansion coefficients which are adapted to one another in the temperature range which occurs in production and use, **in that**
- the housing (8, 15) of the LEDs (1, 24) has a base body which is made of glass or quartz glass or ceramic or glass ceramic,
- the lead frame (3, 10) consists of an Ni-Fe alloy or of a copper cladding wire with a core made of an Ni-Fe alloy and a cladding made of copper, and
- the LEDs emit in the UV range.

2. The surface light source (20) according to claim 1, wherein the LEDs form a pictogram.

## Revendications

1. Unité d'éclairage de surface (20)
comportant une pluralité de DEL (1, 24) arrangées comme pixels individuels d'une matrice constituée par plusieurs lignes et colonnes qui sont appliquées et interconnectées sur un support (21), et qui sont entourées d'un boîtier extérieur commun (22),
**caractérisée en ce que**
- les DEL (1, 24) comprennent chacune un corps semi-conducteur émetteur de rayonnement (2, 12) sur une grille de connexion électroconductrice (3, 10) et un boîtier (8, 15) qui entoure le corps semi-conducteur (2, 12),
- les matériaux du boîtier (8, 15) des DEL (1, 24) et de la grille de connexion (3, 10) possèdent, dans la plage de températures atteinte lors de leur fabrication et de leur emploi, des coefficients d'expansion thermique mutuellement adaptés,
- le boîtier (8, 15) des DEL (1, 24) présentant un corps principal fabriqué en verre ou en verre quartzeux ou en céramique ou en vitrocéramique,
- la grille de connexion (3, 10) se composant d'un alliage Ni-Fe ou d'un fil à gaine en cuivre avec une âme en alliage Ni-Fe et une gaine en cuivre, et
- les DEL (1, 24) émettent dans la plage UV.

2. Unité d'éclairage de surface selon la revendication 1, **caractérisée en ce que** les DEL (1, 24) forment un pictogramme.
